# EUROPÄISCHE PATENTSCHRIFT

(11) **EP 1 761 659 B1**
(45) Veröffentlichungstag und Bekanntmachung des Hinweises auf die Patenterteilung: **02.12.2009**
(21) Anmeldenummer: 05758139.9
(22) Anmeldetag: 20.06.2005
(51) Int. Cl.: C23F 1/34, C23F 1/46, H05K 3/06

(54) **ELEKTROLYTISCH REGENERIERBARE ÄTZLÖSUNG**
ELECTROLYTICALLY RECOVERABLE ETCHING SOLUTION
SOLUTION DE GRAVURE POUVANT ETRE REGENEREE PAR VOIE ELECTROLYTIQUE

(30) Priorität: 25.06.2004 DE 102004030924
(43) Veröffentlichungstag der Anmeldung: 14.03.2007
(73) Patentinhaber: Gebr. Schmid GmbH + Co., 72250 Freudenstadt (DE)
(72) Erfinder: NEHDI, Sadok, Ben, Rejeb, 88696 Owingen (DE)
(74) Vertreter: Patentanwälte Ruff, Wilhelm, Beier, Dauster & Partner
(86) Internationale Anmeldenummer: PCT/EP2005/006622
(87) Internationale Veröffentlichungsnummer: WO 2006/000364

(56) Entgegenhaltungen:
- WO-A-92/01086
- DE-A1- 19 800 605
- US-A- 3 257 160
- US-A- 4 784 785
- ELSTNER, R. ET AL: "Studies on the effect of inhibitors in ammonia etching solutions on the depth and pattern in copper etching" METALLOBERFLAECHE , 36(10), 468-78 CODEN: MOFEAV; ISSN: 0026-0797, 1982, XP009052928

## Beschreibung

Vorliegende Erfindung betrifft eine elektrolytisch regenerierbare Ätzlösung, insbesondere zur Ätzung von Leiterplatten und Formteilen aus Kupfer und Kupfer-Legierungen, bestehend im wesentlichen aus einem Gehalt an Wasser, Ammoniak, Kupfersulfat und Ammoniumsulfat.

Herkömmliche Ätzlösungen werden in vielfältiger Form und Ausführung, insbesondere zum Ätzen von Leiterplatten verwendet. Die Beschleunigung des Ätzprozesses spielt im Fertigungsprozess auch eine grosse Rolle, was eine Beschleunigung des regenerativen Prozesses der Ätzlösung erfordert.

Bei einem Verfahren zur Leiterplattenfertigung wird das Leiterbahnbild mittels Siebdruck oder mittels eines Fotoprozesses auf die Kupferoberfläche als Resistbild aufgebracht. Die vom Resist unbedeckte KupferOberfläche wird dann durch das geeignete Ätzmittel aufgelöst.

Bei einem weiteren Verfahren wird eine zweiseitig bedruckte Leiterplatte so behandelt, dass die Leiterbahnzüge und Durchkontaktierungen durch einen Metallresist geschützt werden. Anschließend wird der zu Beginn aufgebrachte organische Resist gestrippt und das darunter liegende Kupfer wird durch ein geeignetes Ätzmittel aufgelöst. Auf diese Weise sind die Leiterbahnen und Durchkontaktierungen durch den Metallresist vor der Auflösung geschützt.

Zur Fertigung der Leiterplatten werden Ätzlösungen verwendet, die auf der Basis von ammoniakalischen Kupfersalzlösungen arbeiten. Nachteilig ist hieran, dass die Ätzgeschwindigkeit beschränkt ist und ein Regenerierungsverfahren zum Aufbereiten der Ätzlösung nicht hinreichend schnell erfolgt.

Die DE 198 00 605 A1 zeigt eine Ätzlösung für Leiterplatten aus Kufper, bestehend aus Wasser, Ammoniak, Kupfersulfat, Ammoniumsulfat, einem vanadiumhaltigen Katalysator und Natriumhypochlorid als zusätzlichem Katalysator.

Der vorliegenden Erfindung liegt die Aufgabe zugrunde, die Ätzgeschwindigkeit zu beschleunigen und die Regeneration der verbrauchten Ätzlösung zum Wiederverwenden im Prozess und zum Zuführen sowie zum erneuten Ätzen im kontinuierlichen Ätzprozess zu unterstützen.

Zur Lösung dieser Aufgabe führen die Merkmale des Patentanspruchs 1.

Bei der vorliegenden Erfindung hat sich als besonders vorteilhaft erwiesen, den Ätzprozess dadurch zu beschleunigen, indem das Methylenblau als Katalysator wirkt und den Regenerationsprozess der verbrauchten Ätzlösung unterstützt.

Hierdurch wird als Beschleuniger und Katalysator Methylenblau in einer Menge von 10 bis 100 mg je Liter Ätzlösung, vorzugsweise 40 mg je Liter Ätzlösung verwendet.

Das Methylenblau, vorzugsweise als C₁₆H₁₈ClN₃S unterstützt die Oxidation von Cu⁺ in Cu⁺⁺ bei der Regeneration im Regenerationsprozess. Auf diese Weise lässt sich der Regenrationsprozess der Ätzlösung beschleunigen. Die Cu⁺-Ionen hämmen den Ätzprozess, weshalb diese Cu⁺-Ionen durch ein Oxidationsmittel zu Cu⁺⁺ zurückoxidiert werden müssen. Der Ätzprozess erfolgt nach folgender Gleichung:

Cu + [Cu(NH₃)₄]⁺⁺ ←→ 2 [Cu(NH₃)₂]⁺

Die sogenannte Regeneration verläuft mit Ammonium, Ammoniak und Sauerstoff nach folgender Gleichung:

4[Cu(NH₃)₂]⁺ + 4 NH₃ + 4 NH₄⁺ + O₂ ←→4 [Cu(NH₃)₄]⁺⁺ + 2H₂O

Eine Erhöhung der Regenerationsgeschwindigkeit bewirkt im Prozess systematisch eine Erhöhung der Ätzgeschwindigkeit. Das als Katalysator verwendete Vandiumpentoxid oder auch andere Vanadiumverbindungen als Katalysatoren erhöhen zusätzlich die Ätzgeschwindigkeit. Dabei hat sich als besonders vorteilhaft bei der vorliegenden Erfindung erwiesen, zusätzlich zu den vanadiumhaltigen Katalysatoren zur Erhöhung der Ätzgeschwindigkeit bzw. Regenerationsgeschwindigkeit verbrauchter Ätzlösung den zusätzlichen Katalysator, bestehend aus Methylenblau zuzusetzen bzw. zu verwenden.

Hierdurch kann die Ätzgeschwindigkeit sowie die Regenerationsgeschwindigkeit verbrauchter Ätzlösung wesentlich gesteigert werden. Dies spielt insbesondere bei der Leiterplattenfertigung eine grosse Rolle, bei welcher Leiterplatten eine Ätzmaschine durchlaufen und dort die Kupferoberfläche beständig oder in Intervallen übersprüht wird.

Als besonders vorteilhaft haben sich folgende Ätzlösungen erwiesen:
Lösung 1:
   70 bis 100 gr. je Liter Kupfer entsprechend 275 bis 400 gr. je Liter Kupfersulfatpentahydrat (CuSO₄•5H₂O)
   120 bis 240 gr. je Liter Sulfat entsprechend 165 bis 330 gr. je Liter Ammoniumsulfat ((NH₄)₂SO₄)
   0,3 bis 0,6 Liter je Liter Ätzlösung Ammoniakwasser (NH₄OH) als 25%ige Lösung
   0,4 bis 0,6 Liter je Liter Ätzlösung destilliertes Wasser
   100 bis 1000 mg je Liter Ätzlösung Vanadiumpentoxid (V₂O₅)
   10 bis 100 mg je Liter Ätzlösung Methylenblau (C₁₆H₁₈ClN₃S)
Lösung 2:
   85 gr. je Liter Kupfer entsprechend 330 gr. je Liter Kupfersulfat (CuSO₄•5H₂O)
   200 gr. je Liter Sulfat entsprechend 275 gr. je Liter Ammoniumsulfat ((NH₄)₂SO₄)
   0,5 Liter je Liter Ätzlösung Ammoniak (NH₄OH) als 25%ige Lösung
   0,5 Liter je Liter Ätzlösung destilliertes Wasser
   400 mg je Liter Ätzlösung Vanadiumpentoxid (V₂O₅)
   40 mg je Liter Ätzlösung Methylenblau (C₁₆H₁₈ClN₃S)

## Patentansprüche

1. Elektrolytisch regenerierbare Ätzlösung, insbesondere zur Ätzung von Leiterplatten und Formteilen aus Kupfer und Kupfer-Legierungen, bestehend im wesentlichen aus einem Gehalt an Wasser, Ammoniak, Kupfersulfat und Ammoniumsulfat, **dadurch gekennzeichnet, dass** die Ätzlösung als Katalysator Methylenblau enthält.

2. Ätzlösung nach Anspruch 1, **dadurch gekennzeichnet, dass** der Ätzlösung etwa 10 bis 100 mg je Liter Methylenblau zugesetzt sind.

3. Ätzlösung nach Anspruch 1 oder 2, **dadurch gekennzeichnet, dass** die Ätzlösung in etwa 40 mg je Liter Methylenblau enthält.

4. Ätzlösung nach wenigstens einem der Ansprüche 1 bis 3, **dadurch gekennzeichnet, dass** als Katalysator für die Ätzlösung Methylenblau als (C₁₆H₁₈ClN₃S) oder (C₁₆H₁₉N₃S) verwendet wird.

5. Ätzlösung nach wenigstens einem der Ansprüche 1 bis 4, **dadurch gekennzeichnet, dass** ein pH-Wert der Ätzlösung auf einen pH-Wert von etwa 8,0 bis 9,6, insbesondere 8,4 eingestellt wird.

6. Ätzlösung nach wenigstens einem der Ansprüche 1 bis 5, **dadurch gekennzeichnet, dass** die Ätzlösung Cu⁺⁺ von 70 gr. bis 100 gr. je Liter enthält.

7. Ätzlösung nach wenigstens einem der Ansprüche 1 bis 6, **dadurch gekennzeichnet, dass** die Ätzlösung 275 bis 400 gr. je Liter, bevorzugt 330 gr. je Liter Kupfersulfatpentahydrat enthält.

8. Ätzlösung nach wenigstens einem der Ansprüche 1 bis 7, **dadurch gekennzeichnet, dass** sie 120 bis 240 gr. je Liter Sulfate, bevorzugt 200 gr. Sulfate, entsprechend 165 bis 330 gr. je Liter Ammoniumsulfat ((NH₄)₂SO₄) enthält.

9. Ätzlösung nach wenigstens einem der Ansprüche 1 bis 8, **dadurch gekennzeichnet, dass** sie je Liter 0,3 bis 0,6 Liter 25%iges Ammoniakwasser (NH₄OH) enthält.

10. Ätzlösung nach wenigstens einem der Ansprüche 1 bis 9, **dadurch gekennzeichnet, dass** sie je Liter 0,4 bis 0,6 Liter Wasser enthält.

11. Ätzlösung nach wenigstens einem der Ansprüche 1 bis 10, **dadurch gekennzeichnet, dass** sie etwa 100 bis 1000 mg je Liter Vanadiumpentoxid oder entsprechende andere Vanadiumverbindungen enthält.

12. Ätzlösung nach Anspruch 11, **dadurch gekennzeichnet, dass** die Ätzlösung in etwa 400 mg je Liter Vanadiumpentoxid (V₂O₅) enthält.

13. Ätzlösung nach wenigstens einem der Ansprüche 1 bis 12, **dadurch gekennzeichnet, dass** diese etwa von 1 gr. bis 80 gr., bevorzugt 15 gr. je Liter Nitrat enthält.

14. Ätzlösung nach Anspruch 13, **dadurch gekennzeichnet, dass** der Gesamtanteil an Sulfaten, aus Kupfersulfat und/oder Ammoniumsulfat 120 gr. bis 240 gr. je Liter beträgt.

15. Ätzlösung nach Anspruch 13 oder 14, **dadurch gekennzeichnet, dass** die Summe aus Gesamtsulfat und Nitrat 200 gr. bis 240 gr., bevorzugt 215 gr. je Liter beträgt.

16. Ätzlösung nach wenigstens einem der Ansprüche 1 bis 15, **dadurch gekennzeichnet, dass** sie ständig oder in wählbaren Intervallen mit Sauerstoff oder Luft begast wird.

17. Ätzlösung nach wenigstens einem der Ansprüche 1 bis 16, **dadurch gekennzeichnet, dass** eine Temperatur der Ätzlösung etwa 45 bis 55°C, vorzugsweise 50°C beträgt.

## Claims

1. Electrolytically regenerable etching solution, in particular for etching circuit boards and molded parts of copper and copper alloys, comprising essentially water, ammonia, copper sulphate and ammonium sulphate, **characterized in that** the etching solution comprises methylene blue as a catalyst.

2. Etching solution according to claim 1, **characterized in that** the etching solution comprises approximately 10 to 100 mg of methylene blue per litre.

3. Etching solution according to claim 1 or 2, **characterized in that** the etching solution comprises approximately 40 mg of methylene blue per litre.

4. Etching solution according to at least one of the claims 1 to 3, **characterized in that**, as a catalyst for the etching solution, methylene blue as (C₁₆H₁₈ClN₃S) or (C₁₆H₁₉N₃S) is used.

5. Etching solution according to at least one of the claims 1 to 4, **characterized in that** a pH value of the etching solution is set to a pH value of approximately 8,0 to 9,6, in particular 8,4.

6. Etching solution according to at least one of the claims 1 to 5, **characterized in that** the etching solution comprises from 70 g to 100 g of Cu⁺⁺ per litre.

7. Etching solution according to at least one of the claims 1 to 6, **characterized in that** the etching solution comprises 275 to 400 g per litre, preferably 330 g, of copper sulphate pentahydrate per litre.

8. Etching solution according to at least one of the claims 1 to 7, **characterized in that** it comprises 120 to 240 g of sulphates per litre, preferably 200 g of sulphates, per litre, corresponding to 165 to 330 g of ammonium sulphate ((NH₄)₂SO₄) per litre.

9. Etching solution according to at least one of the claims 1 to 8, **characterized in that** it comprises 0,3 to 0,6 litres of 25% ammonium hydroxide (NH₄OH) per litre.

10. Etching solution according to at least one of the claims 1 to 9, **characterized in that** it comprises 0,4 to 0,6 litres of water per litre.

11. Etching solution according to at least one of the claims 1 to 10, **characterized in that** it comprises approximately 100 to 1000 mg of vanadium pentoxide or other appropriate vanadium compounds, per litre.

12. Etching solution according to claim 11, **characterized in that** the etching solution comprises approximately 400 mg of vanadium pentoxide (V₂O₅) per litre.

13. Etching solution according to at least one of the claims 1 to 12, **characterized in that** it comprises approximately 1 to 80 g, preferably 15 g, of nitrate per litre.

14. Etching solution according to claim 13, **characterized in that** the total content of sulphates, copper sulphate and/or ammonium sulphate, is 120 to 240 g per litre.

15. Etching solution according to claim 13 or 14, **characterized in that** the sum of the total content of sulphate and nitrate is 200 to 240 g, preferably 215 g, per litre.

16. Etching solution according to at least one of the claims 1 to 15, **characterized in that** it is provided with oxygen or air continuously or at selectable intervals.

17. Etching solution according to at least one of the claims 1 to 16, **characterized in that** a temperature of the etching solution is approximately 45 to 55°C, preferably 50°C.

## Revendications

1. Solution d'attaque chimique à régénération électrolytique, notamment pour l'attaque de plaques à circuit imprimé ou de pièces préformées en cuivre et en alliage cuivreux, contenant essentiellement de l'eau, de l'ammoniac, du sulfate de cuivre et du sulfate d'ammonium, **caractérisé en ce que** la solution d'attaque contient du bleu de méthylène comme catalyseur.

2. Solution d'attaque d'après la revendication 1, **caractérisée en ce qu'**on ajoute à la solution d'attaque à peu près entre 10 et 100 mg par litre de bleu de méthylène.

3. Solution d'attaque d'après la revendication 1 ou 2, **caractérisée en ce que** la solution d'attaque contient à peu près 40 mg par litre de bleu de méthylène.

4. Solution d'attaque d'après au moins une des revendications de 1 à 3, **caractérisée en ce qu'**on emploie comme catalyseur pour la solution d'attaque du bleu de méthylène sous forme de (C₁₆H₁₈CIN₃S) ou bien (C₁₆H₁₉N₃S).

5. Solution d'attaque d'après au moins une des revendications de 1 à 4, **caractérisée en ce qu'**un pH de la solution d'attaque est ajusté à une valeur entre 8,0 et 9,6 et notamment à 8,4.

6. Solution d'attaque d'après au moins une des revendications de 1 à 5, **caractérisée en ce que** la solution d'attaque contient entre 70 gr et 100 gr par litre de Cu⁺⁺.

7. Solution d'attaque d'après au moins une des revendications de 1 à 6 **caractérisée en ce que** la solution d'attaque contient entre 275 et 400 gr par litre et notamment 330 gr par litre de sulfate de cuivre pentahydraté.

8. Solution d'attaque d'après au moins une des revendications de 1 à 7 **caractérisée en ce qu'**elle contient entre 120 et 240 gr par litre, de préférence 200 gr de sulfates, et entre 165 et 330 gr par litre de sulfate d'ammonium ((NH₄)₂SO₄).

9. Solution d'attaque d'après au moins une des revendications de 1 à 8 **caractérisée en ce qu'**elle contient entre 0,3 et 0,6 litres par litre de solution d'attaque de hydroxyde d'ammonium (NH₄OH) en solution à 25%.

10. Solution d'attaque d'après au moins une des revendications de 1 à 9 **caractérisée en ce qu'**elle contient entre 0,4 et 0,6 litres d'eau par litre de solution d'attaque.

11. Solution d'attaque d'après au moins une des revendications de 1 à 10 **caractérisée en ce qu'**elle contient entre 100 et 1000 mg par litre de pentoxyde de vanadium ou bien d'autres composés du vanadium correspondants.

12. Solution d'attaque d'après la revendication 11 **caractérisée en ce que** la solution d'attaque contient à peu près 400 mg par litre de pentoxyde de vanadium (V₂O₅).

13. Solution d'attaque d'après au moins une des revendications de 1 à 12 **caractérisée en ce qu'**elle contient entre 1 gr et 80 gr, de préférence 15 gr par litre de nitrate.

14. Solution d'attaque d'après la revendication 13 **caractérisée en ce que** le taux global de sulfates, comprenant du sulfate de cuivre et/ou du sulfate d'ammonium, comporte entre 120 gr et 240 gr par litre.

15. Solution d'attaque d'après la revendication 13 ou 14 **caractérisée en ce que** le total comprenant les sulfates et le nitrate comporte entre 200 gr et 240 gr, de préférence 215 gr par litre.

16. Solution d'attaque d'après au moins une des revendications de 1 à 15 **caractérisée en ce qu'**on injecte de l'oxygène ou bien de l'air dans la solution d'attaque par gazage constant ou bien opérant par intervalles librement choisis.

17. Solution d'attaque d'après au moins une des revendications de 1 à 16 **caractérisée en ce qu'**une température de la solution d'attaque comporte à peu près entre 45 et 55°C, de préférence 50°C.
